# EUROPEAN PATENT APPLICATION

(11) **EP 1 916 701 A2**
(43) Date of publication of application: **30.04.2008**
(21) Application number: 07018001.3
(22) Date of filing: 13.09.2007
(51) Int. Cl.: H01L 21/00

(54) **Facility connection positioning template**

(30) Priority: 27.10.2006 US 863319 P
(71) Applicant: APPLIED MATERIALS, INC., Santa Clara, California 95054 (US)
(72) Inventor: Gomez, Oscar, South San Francisco CA 94080 (US); Robinson, Jeffrey Barrett, San Jose CA 95123 (US); Foster, Jason Kirk, San Jose CA 95125 (US); Buckius, Duc Dang, Union City CA 94587 (US)
(74) Representative: Zimmermann, Gerd Heinrich

(57) **Abstract**

One embodiment of an apparatus includes a flat, plate-shaped template (100, 200) adapted for facilities integration. The template defines a plurality of apertures (102, 202) arranged in a predetermined pattern of locations, each template aperture adapted to position a facility conduit passing through each template aperture in a predetermined location to facilitate subsequently coupling the positioned facility conduit to the wafer processing tool. Other embodiments are described and claimed.

## Description

Embodiments of the present invention generally relates to semiconductor wafer facilities. In particular, it relates to facility conduits connections for wafer processing tools. More specifically, it relates to apparatuses for installing a plurality of facility conduits in a wafer fabrication facility and methods for installing a plurality of facility conduits in a wafer fabrication facility.

Integrated circuits have evolved into complex devices that include millions of devices including transistors, capacitors and resistors, on a single chip. The evolution of chip designs has provided faster circuitry and greater circuit density. As the demand for integrated circuits continue to rise, chip manufacturers have demanded semiconductor process tooling having increased wafer throughput and greater product yield. To meet this increase in throughput, tooling has been developed to process ever wider diameter wafers, for example, wafers having diameters of 300 millimeters (mm).

The chip manufacturers order semiconductor wafer processing tools from semiconductor processing tool manufacturers, such as Applied Materials, Inc., of Santa Clara, Calif. Prior to delivery of the semiconductor wafer processing tool, the chip manufacturer typically prepares the facility to receive and install the tool. Preparations include establishing placement of where the tool is to be located in a room, and providing the necessary facility conduits ("rough plumbing") to carry electricity and fluids including process and exhaust gases, and liquids including water, coolants and process chemicals between the power, gas and liquid sources of the facilities and the processing tool. A footprint of the tool is provided to the chip manufacturer for laying out the facility conduits.

Floor measurements may be taken of the wafer processing facility using X-Y coordinates, which include distances from walls, structures, and the like. In addition, measurements of the tool are taken, or templates, such as thin film Mylar templates of the tool footprint may be provided to determine the positioning of the wafer processing tool in a room at the facility as well as cutouts in a facility floor. Other methods may be utilized to determine the positioning of the wafer processing tool in the room at the facility.

Once rough plumbing of the facility conduits has been installed or at least laid out, the plumbing lines can be extended through the floor for subsequent connection to the processing tool. However, it has been observed that upon delivery of the processing tool to the chip manufacturer's facility, the facility conduits can obstruct the final positioning of the processing tool. As such, positioning the processing tool can be cumbersome and the facility conduits may be damaged. Furthermore, additional time is taken to complete the facility conduits connections to the wafer processing tool once the wafer processing tool is positioned. This is often experienced in connection with the installation of gas lines which are often hard line facility conduits that can be relatively inflexible.
In light of the above, an apparatus for installing a plurality of facility conduits according to independent claim 1, and a method of installing a plurality of facility conduits according to independent claim 14 are provided.
Further advantages, features, aspects and details of the invention are evident from the dependent claims, the description and the drawings.

Embodiments are directed to a method and apparatus for installing a semiconductor substrate processing tool at a semiconductor substrate fabrication facility. One embodiment includes a semiconductor substrate processing tool installation template. In an illustrated embodiment, an apparatus includes a flat, plate-shaped template adapted for facilities integration. The template defines a plurality of apertures arranged in a predetermined pattern of locations, each template aperture adapted to position a facility conduit passing through each template aperture in a predetermined location to facilitate subsequently coupling the positioned facility conduit to the wafer processing tool.

In another embodiment, a method of installing a plurality of facility conduits in a wafer fabrication facility for subsequent coupling to a wafer processing tool includes determining a location where a wafer processing tool is to be positioned in a wafer fabrication facility; forming a cutout in a floor of the fabrication facility corresponding to the location; providing a plurality of facility conduits through the cutout in the floor; mounting a flat, plate-shaped template defining a plurality of apertures arranged in a predetermined pattern of locations, to the floor and over the cutout in the floor; passing a facility conduit through each template aperture to position the facility conduit passing through each template aperture in a predetermined location; and coupling the wafer processing tool to the facility conduits.

Other embodiments are described and claimed.

Examples of embodiments of the present invention will now be described with reference to the drawings in which:
FIG. 1 depicts a perspective view of a facilities integration template in accordance with one embodiment of the present description;
FIG. 2 depicts a top view of another example of a facilities integration template in accordance with the present description;
FIG. 3 depicts a top view of the semiconductor wafer processing tool and examples of positions in which the templates of FIGs. 1 and 2 may be utilized in the installation of such a tool;
FIG. 4 is a flow chart depicting one example of operations for installing the semiconductor wafer processing tool to the plurality of facility conduits utilizing the facilities integration templates of FIGs. 1 and 2;
FIG. 5 depicts a perspective of a floor for supporting a semiconductor wafer processing tool wherein the floor employs facilities integration templates of FIGs. 1 and 2 for the installation of a wafer processing tool such as that depicted in FIG. 3;
FIG. 6 depicts a side view of a facilities integration template of FIG. 1, shown mounted on a floor with a facility conduit extending therethrough; and
FIG. 7 depicts a top view of a facilities integration template of FIG. 1.
To facilitate understanding, identical reference numerals have been used, where possible, to designate identical elements, which are common to the figures.

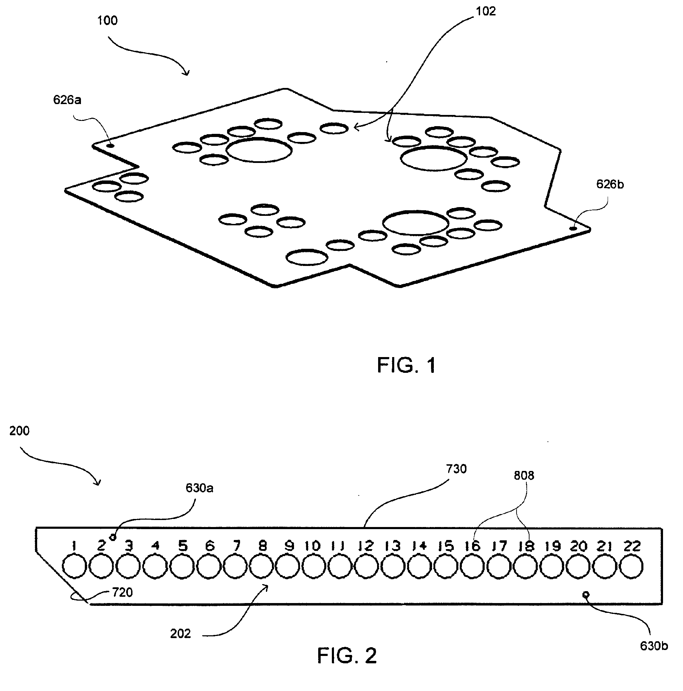

A template in accordance with one embodiment of the present description is indicated generally at 100 in FIG. 1. The template 100 of this embodiment is flat and plate-shaped and defines a plurality of apertures 102 arranged in a predetermined pattern of locations. As explained in greater detail below, each template aperture 102 is adapted to position a facility conduit passing through the associated template aperture in a predetermined location to facilitate subsequently coupling the positioned facility conduit to the wafer processing tool.

A template in accordance with another embodiment of the present description is indicated generally at 200 in FIG. 2. The template 200 of this embodiment, like the template 100 of FIG. 1, is flat and plate-shaped and defines a plurality of apertures 202 arranged in a predetermined pattern of locations. In a manner similar to that of the template 100, each template aperture 202 is adapted to position a facility conduit passing through the associated template aperture 202 in a predetermined location to facilitate subsequently coupling the positioned facility conduit to the wafer processing tool.

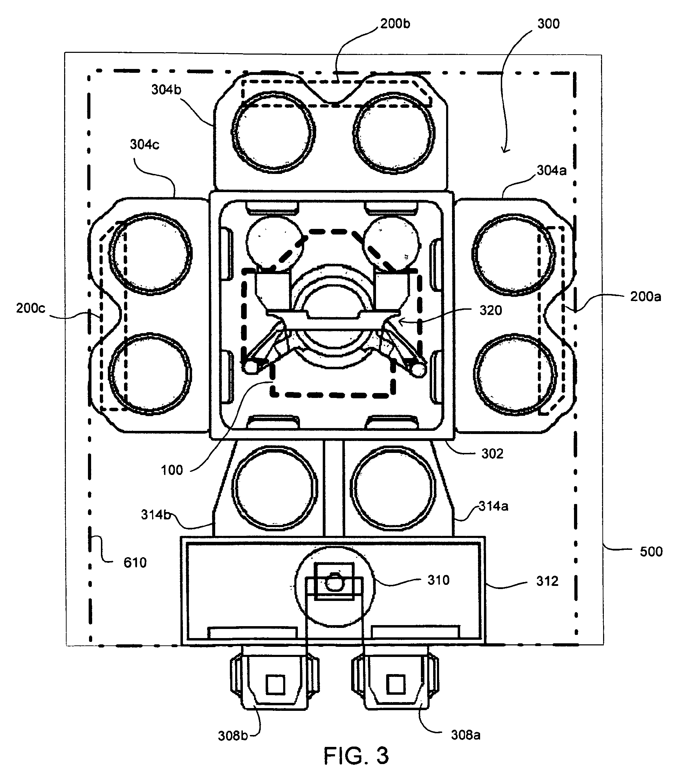

FIG. 3 shows an example of a wafer processing tool 300 which may be installed using templates such as the templates 100, 200 in accordance with the present description. In this example, the wafer processing tool 300 is a PRODUCER GT^{™} dielectric film deposition system, manufactured and sold by Applied Materials, Inc. of Santa Clara, Calif. However, it should be understood that templates in accordance with the present description may be used to install other chamber configurations such as other chemical vapor deposition chambers, physical vapor deposition chambers, etch chambers, ion implant chambers, and other semiconductor processing chambers.

The wafer processing tool 300 of the illustrated embodiment includes a mainframe transfer chamber 302 to which are coupled three wafer processing chambers 304a, 304b and 304c. In this example, the template 100 (indicated in phantom in FIG. 3) is utilized in the installation of the mainframe transfer chamber 302 and the three wafer processing chambers 304a, 304b and 304c of the tool 300. In addition, three templates 200a, 200b, 200c (indicated in phantom in FIG. 3), each of them being similar to the template 200 of FIG. 1, are utilized in the installation of the three wafer processing chambers 304a, 304b and 304c, respectively. As explained in greater detail below, the templates 100, 200a, 200b, 200c may be removed prior to actual installation of the tool 300.

Wafers to be processed are unloaded from one or both of a pair of pods or cassettes 308a, 308b by a robot 310 of a factory interface 312. The robot 310 loads the wafers to be processed into one or both of a pair of load lock chambers 314a, 314b which upon being sealed, are pumped down to or near the operating pressure of the mainframe transfer chamber 302. Many wafer transfer and processing chambers typically operate at very low pressures, often near vacuum levels.

Once the pressure of the load lock chambers is sufficiently low, the load lock chambers 314a, 314b are opened to the mainframe transfer chamber 302 and a robot 320 of the mainframe transfer chamber 302 transfers the wafers to one of the processing chambers 304a, 304b, 304c. Upon completion of the processing, wafers are returned to the load lock chambers 314a, 314b. Once the pressure of the load lock chambers returns to ambient, the load lock chambers 314a, 314b are opened to the factory interface 312. The robot 310 transfers the processed wafers to one or both of the pods 308a, 308b. It should be appreciated that the foregoing description is of one example of the construction and operation of a wafer processing tool which may be installed utilizing templates in accordance with the present description. The construction and operation of the tool may vary, depending upon the particular processing operations being conducted, the number of wafers being processed and other factors which will be known to those skilled in the art.

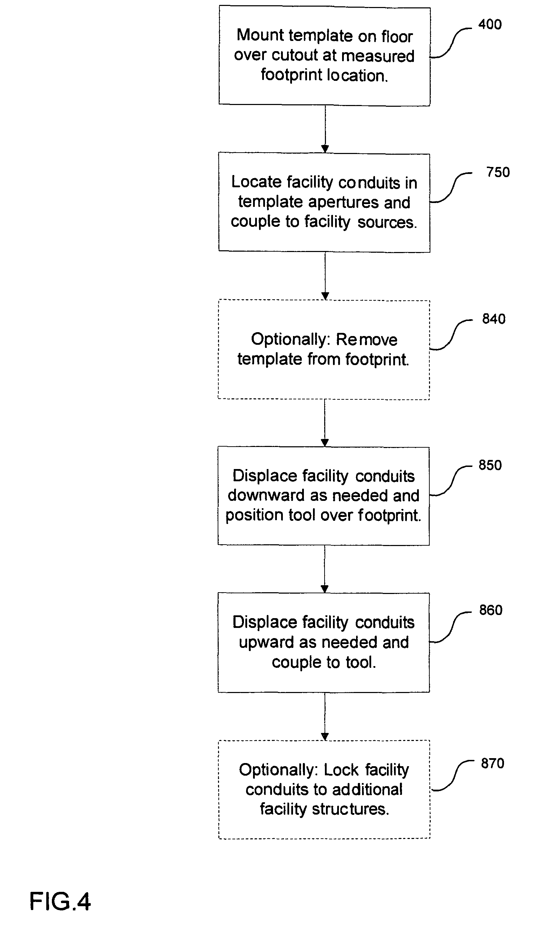

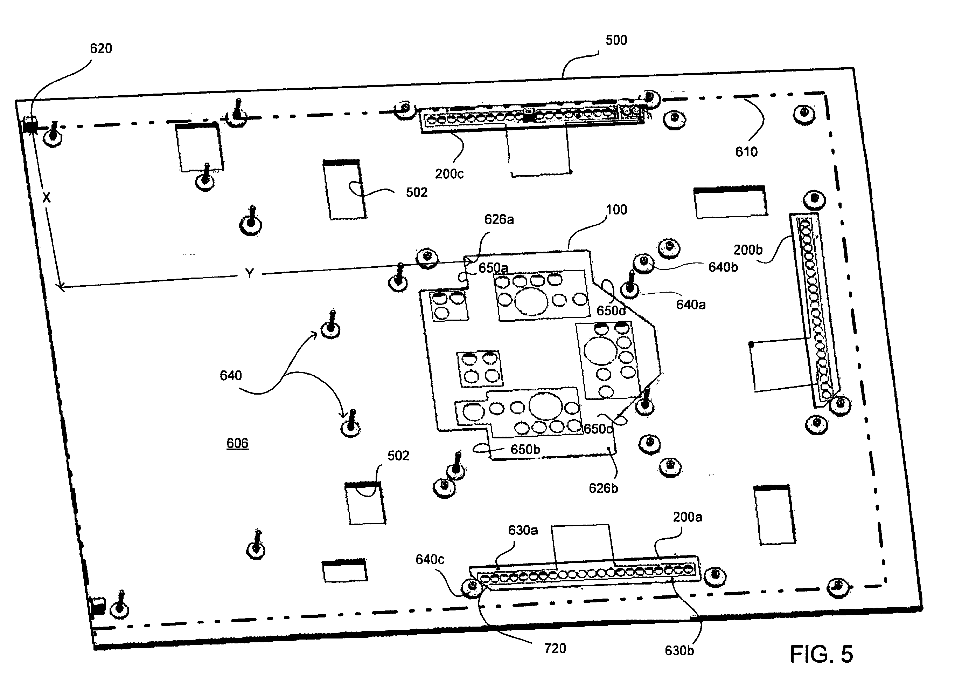

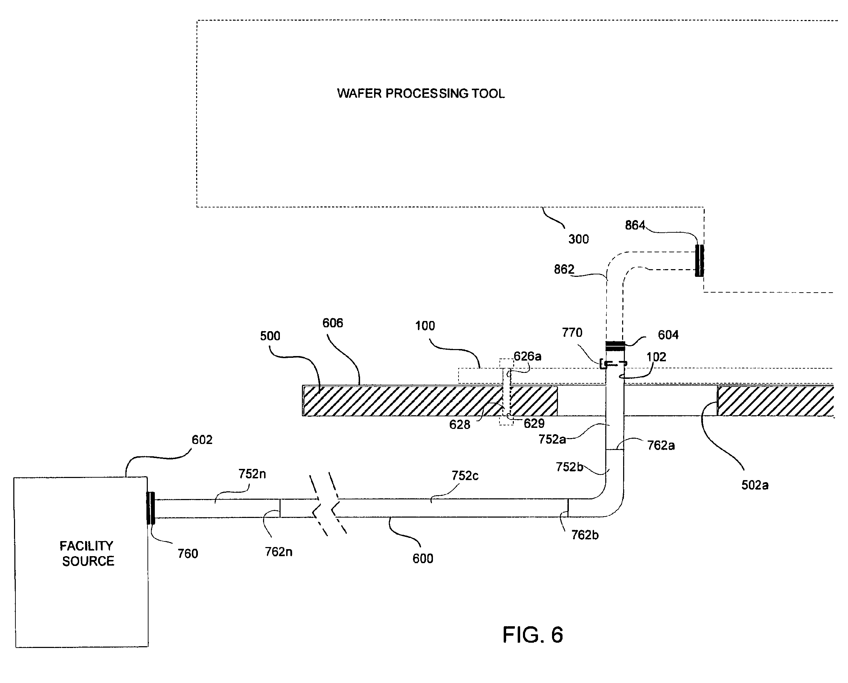

FIG. 4 provides one example of operations to install a wafer processing tool utilizing one or more templates, in accordance with the present description. In one operation, a template such as the template 100, for example, is mounted (block 400) on a floor over a cutout at a measured footprint location. FIG. 5 shows an example of a facility floor 500 which in this embodiment, is a raised floor as schematically represented in FIG. 6. The facility floor 500 defines a plurality of cutouts 502 through which facility conduits may pass from beneath the floor 500 to a space above the floor 500 for coupling to the wafer processing tool 300. The facility conduits include gas supply conduits, gas exhaust conduits, gas vent conduits, liquid supply conduits, liquid return conduits, gas return conduits, and power conduits. FIG. 6 shows one example of a cutout 502a through which a facility conduit 600 passes from a facility source 602, under the facility raised floor 500, through the floor cutout 502a and terminates with a connect-disconnect coupler 604 above the top surface 606 of the floor 500. The connect-disconnect coupler 604 may be suitable disconnectable coupler such as VCR connectors, N25 flanges, SWAGELOCK^{™} fittings, pressure fittings, etc.

As best seen in FIGs. 3, 5 the wafer processing tool 300 defines a footprint 610 over the facility floor 500. The footprint 610 includes the length and breadth of the outer periphery of the tool 300 and also various locations which correlate with tool connection points at which the facility conduits are coupled to the tool. In anticipation of the installation of the tool 300, various connection point locations of the footprint 610 may be laid out on the floor 500. In that facility conduits will often pass through the facility floor 500 at or near these connection point locations of the footprint 610, cutouts 502 may be formed in the floor 500 to accommodate the facility conduits passing through the floor 500 for subsequent coupling to the tool 300 once it is installed on the floor 500.

The various locations of the footprint 610 may be measured relative to a datum point 620 affixed to the facility floor 500. Each such footprint location may be determined as a two dimensional (x, y) displacement from the datum point 620. In accordance with another aspect of the present description, the template 100 has a pair of fastener apertures 626a, 626b which receive fasteners which fasten the template to the top surface 606 of the facility floor 500. The fastener apertures 626a, 626b and the fastener points of the floor 500 at which fasteners pass through the fastener apertures 626a, 626b and the floor 500 to fasten the template 100 to the facility floor 500, may be used as registration points to precisely position the template 100 within the footprint of the tool 300 to be installed.

FIG. 6 shows an example of a fastener 628 passing through a fastener aperture 626a of the template 100 and a template fastening point 629 of the facility floor 500. Thus, the x, y displacements of the template fastener apertures 626a, 626b and the template fastening points 629 of the floor 500 relative to the floor datum point 620 may be measured to ensure that the template 100 is properly located within the footprint 610 and over the associated floor cutouts. Once properly located, the template 100 may be fastened in place at that location. In the illustrated embodiment, removable fasteners such as threaded bolts, machine screws, etc. are used to fasten the template 100 in place to permit the template 100 to be removed prior to actual installation of the tool 300 itself.

In a similar manner, each template 200a, 200b, 200c has a pair of fastener apertures 630a, 630b which receive fasteners which fasten the template 200a, 200b, 200c to the top surface 606 of the facility floor 500. The fastener apertures 630a, 630b and associated template fastening points of the floor 500 may here too be used as registration or fiducial points to precisely position the template 200a, 200b, 200c within the footprint of the tool 300 to be installed. Thus, the x, y displacements of the fastener apertures 630a, 630b and associated template fastening points of the floor 500 relative to the floor datum point 620 may be measured to ensure that the template 200a, 200b, 200c is properly located within the footprint 610 and over the associated floor cutouts. Once, properly located, the template 200a, 200b, 200c may be fastened in place at that location. In the illustrated embodiment, removable fasteners such as threaded bolts, machine screws, etc. are used to fasten the template 200a, 200b, 200c in place to permit the template 200a, 200b, 200c to be removed prior to actual installation of the tool 300 itself.

It is appreciated that other types of fasteners may be used to fasten a template 100, 200a, 200b, 200c to the floor of a facility, depending upon the particular application. It is further appreciated that registration or fiducial points other than fastener apertures and fastening points may be used to locate the template within the tool footprint on the floor. For example, fiducial points may be silk screened or otherwise imprinted or embossed or cut into the template. It is further appreciated that other locations and other numbers of locations on the template may be used as registration or fiducial points.

As best seen in FIG. 5, the facility floor 500 has a plurality of fixtures 640 affixed to the top surface 606 of the floor 500. These fixtures may include for example, leveling feet for leveling the tool 300 once it is installed above the floor 500. In accordance with another aspect of the present description, the template 100 defines a plurality of recesses 650a, 650b, 650c, 650d positioned on the periphery of the template and adapted to receive protruding facility floor fixtures such as the leveling feet 640. Thus, for example, the template recess 650d receives the leveling feet 640a, 640b. As a consequence, these leveling feet do not obstruct the template 100 to permit the template 100 to be fastened on and parallel to the floor top surface 606 as shown in FIG. 6.

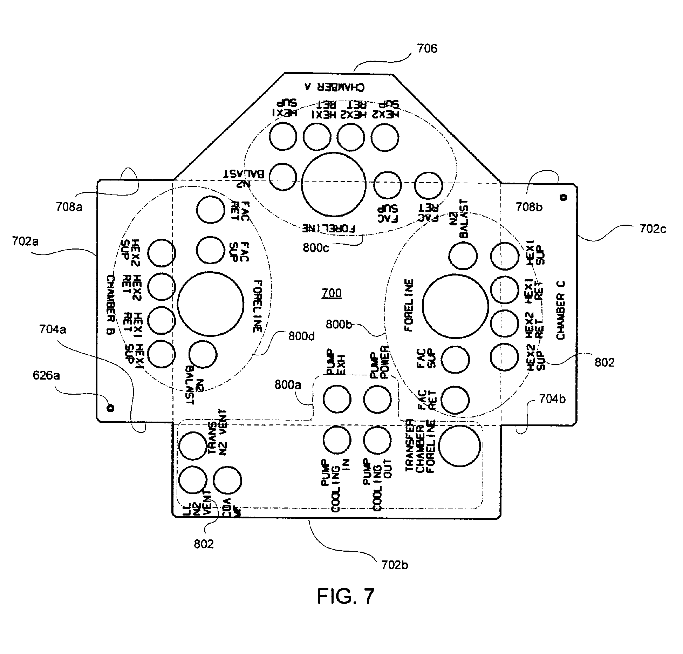

Referring to FIG. 7, the template 100 of the illustrated embodiment has a generally rectangular shaped central portion 700 and three generally rectangular extension portions 702a, 702b, 702c which define two generally orthogonally angled recesses 704a, 704b. The template 100 further has a generally trapezoidal shaped extension portion 706 which defines with two rectangular extension portions 702a, 702c, two generally obtuse angled recesses 708a, 708b. Such an arrangement is believed to facilitate fastening the template 100 flat on and parallel to the floor top surface 606.

In a similar manner, each template 200a, 200b, 200c defines a recess 720 positioned on the periphery of the template and adapted to receive protruding facility floor fixtures such as the leveling feet 640. Thus, for example, the template recess 720 of the template 200a receives the leveling feet 640c as shown in FIG. 5. As a consequence, these leveling feet do not obstruct the templates 200a, 200b, 200c to permit these templates to be fastened on and parallel to the floor top surface 606 in a similar manner as that as shown in FIG. 6 for the template 100.

Referring to FIG. 2, the template 200 of the illustrated embodiment (similar to the templates 200a, 200b, 200c) has a generally rectangular shaped central portion 730 which defines an angled or chamfered corner recess 720. Such an arrangement is believed to facilitate fastening the templates 200, or 200a, 200b, 200c flat on and parallel to the floor top surface 606.

Although specific shapes of the templates 100, 200, 200a, 200b, 200c with their associated arrangements and shapes of recesses have been illustrated and described, it should be appreciated that a variety of shapes and arrangements may be utilized, depending upon the particular application. Nonetheless, it is believed that the particular embodiments described and illustrated herein, have particular suitability for the illustrated application and other applications as well.

As each template 100, 200a, 200b, 200c is mounted (block 400, FIG. 4) on the floor 500 over the appropriate cutoff at a measured location of the footprint 610, the associated facility conduits may be located (block 750) in the appropriate aperture of that template and coupled to a facility source such as the source 602 (FIG. 6). For example, FIG. 6 shows an upright portion 752a of a facility conduit 600 extending through an aperture 102 of the template 100 which has been mounted to the raised floor 500 over a cutoff 502a at a measured location of the footprint 610. In this example, the aperture 102 is sized to circumscribe the upright portion 752a of the facility conduit 600 and to permit the upright portion 752a and its connect-disconnect coupler 604 to pass through the aperture 102 of the template 100.

Further in this example, the facility conduit 600 may be a weldment, that is, a welded assembly of component portions 752a, 752b ... 752n. The number and lengths of the component portions 752a, 752b ... 752n may depend upon the length and directions of the path between the template aperture 102 and the facility source 602. In many applications, such as gas conduits, for example, nonpermanent couplers such as connect-disconnect couplers are to be avoided in conduit runs from a facility source to the raised floor of a wafer processing tool. Hence, the facility conduit 600 of the example of FIG. 6 has only permanent joints such as welded joints sealing the component portions 752a, 752b ... 752n together. The facility conduit 600 has the connect-disconnect coupler 604 at one end above the raised floor 500, for subsequent coupling to a tool conduit leading to the tool 300. In addition, the facility conduit 600 has a connect-disconnect coupler 760 at its other end for subsequent coupling to the facility source 602. However, between the connect-disconnect couplers 604, 760, the facility conduit 600 of the example of FIG. 6 has only permanent joints such as welded joints 762a, 762b, ... 762n sealing the component portions 752a, 752b ... 752n together. It is appreciated that in other applications, a facility conduit may include nonpermanent couplers such as connect-disconnect couplers in intermediate positions between the tool raised floor and the facility source.

When all the joints 762a, 762b ... 762n are welded, the flexibility of the facility conduit 600 is substantially limited. Hence, in many applications, it may be appropriate to insert an upright portion 752a of a facility conduit 600 through the template aperture 102 before completing the welding of all the joints 762a, 762b ... 762n of the facility conduit 600. Because the template 100 has been positioned and mounted (block 400) at a measured footprint location, and the aperture 102 of FIG. 6 together with the other apertures 102 of the template 100, is arranged in a predetermined pattern of locations, the upright portion 752a of the facility conduit 600 is likewise located at a predetermined location of the tool footprint 610 when inserted into the appropriate aperture 102 of the template 100.

The connect-disconnect coupler 604 of the upright portion 752a may be temporarily secured flush with the floor surface 606 or at an appropriate height above the floor upper surface 606 by use of a clamp 770 or other suitable device temporarily attached to the upright portion 752a. Once the upright portion 752a has been inserted into the appropriate template aperture 102 and secured at the appropriate height, the facility conduit 600 may be completed. The order in which joints are welded and the facility conduits are coupled to the source 602 may vary depending upon the particular application. Also, for some facility conduits, it may be appropriate to complete the facility conduit from the facilities source to the raised floor before inserting the free end through the appropriate template aperture. Also, some facility conduits may be sufficiently flexible, such as flexible hoses or alternating current (AC) power conduits, such that the installation may be completed in any order.

As previously mentioned, the apertures 102 of the template 100 are arranged in a predetermined pattern of locations. FIG. 7 shows one example of such a predetermined pattern which defines four separate and distinct clusters 800a, 800b, 800c, 800d of template apertures. Cluster 800a of apertures is for locating facility conduits for the mainframe 302. Clusters 800b, 800c, 800d are for locating facility conduits for the wafer processing chambers, 304a, 304b, 304c respectively.
In the illustrated embodiment, the clusters 800a, 800b, 800c, 800d do not overlap. Cluster 800a resides primarily in the longer rectangular extension portion 702b of the template 100. Clusters 800b and 800d extend into the shorter rectangular extension portions 702c and 702a, respectively. Cluster 800c extends into the trapezoidal shaped extension portion 706. It is appreciated that other patterns of locating apertures may be used, depending upon the particular application. However, it is believed that the pattern illustrated in FIG. 7 is particularly suitable for the illustrated application as well as other applications.

In another aspect, the apertures of each cluster are labeled with suitable label indicia 802, identifying the function of the facility conduit to be located by the associated aperture. Table 1 below identifies the function of each facility conduit to be located by the apertures of the cluster 800a:

**Table 1**

| **Aperture Label** | **Facility Conduit Function** |
|---|---|
| LL N2 VENT | Load lock nitrogen gas vent line |
| TRANS N2 VENT | Mainframe transfer chamber nitrogen vent line |
| CDA MF | Mainframe transfer chamber compressed dry air supply line |
| PUMP COOLING IN | Pump cooling fluid supply line |
| PUMP COOLING OUT | Pump cooling fluid return line |
| PUMP EXH | Pump exhaust line |
| PUMP POWER | Pump power line |
| TRANSFER CHAMBER FORELINE | Mainframe transfer chamber primary exhaust line |

Table 2 below identifies the function of each facility conduit to be located by the apertures of the cluster 800b:

**Table 2**

| **Aperture Label** | **Facility Conduit Function** |
|---|---|
| FAC RET | Facility water return line |
| FAC SUP | Facility water supply line |
| FORELINE | Wafer processing chamber primary exhaust line |
| N2 BALAST | Nitrogen ballast line |
| HEX2 SUP | Heat exchange coolant supply line |
| HEX2 RET | Heat exchange coolant return line |
| HEX1 SUP | Heat exchange coolant supply line |
| HEX1 RET | Heat exchange coolant return line |

The clusters 800c and 800d are labeled in a similar manner to that of the cluster 800b and the functions of the corresponding facility conduits are similar as well for the associated wafer processing chambers. It is appreciated that the arrangement of the functions of the facility conduits corresponding to the template 100 may be varied depending upon the particular application. However, it is believed that the arrangement of facility conduit functions illustrated in FIG. 7 is particularly suitable for the illustrated application as well as other applications.

The identifying indicia 802 may be silk screened on the templates 100, 200a, 200b, 200c. However other identifying markings may be utilized such as labels, engraving, and the like.

In another aspect of the present description, the apertures 202 of the template 200a, 200b, 200c are arranged in a predetermined pattern of locations. FIG. 2 shows one example of such a predetermined pattern in which the apertures 202 for a template 200 are arranged aligned along a single straight axis which extends the length of the template 200. It is appreciated that other patterns of locating apertures 202 may be used, depending upon the particular application. However, it is believed that the pattern illustrated in FIG. 2 is particularly suitable for the illustrated application as well as other applications.

In yet another aspect, the apertures of the templates 200a, 200b, 200c are labeled with suitable label indicia 808, uniquely identifying each aperture. In the illustrated embodiment, each aperture 202 has a unique number label such as "1 ", "2", "3" ... n, depending upon the number of apertures of the template. Each numbered aperture may be assigned to locate a particular facility conduit as appropriate for that particular application.

Once all of the facility conduits associated with the templates 100. 200a, 200b, 200c have been located (block 750, FIG. 4) in the appropriate aperture of the associated template and coupled to a facility source such as the source 602, the templates 100, 200a, 200b, 200c may optionally be removed (block 840). It is believed that the locations of the facility conduits within the footprint 610 can be sufficiently maintained notwithstanding the removal of the templates in many applications. For example, for relatively stiff facility conduits such as gas line conduits, it is believed that the relative stiffness of such facility conduits extending back from the floor 500 to the associated facility source can adequately maintain the facility conduit in place. For facility conduits which are more flexible, movement of the conduits after the templates are removed may be accommodated by moving the conduits back after the tool is in place.

To prepare the tool site for installation of the tool 300, one or more of the facility conduits extending above the top surface 606 of the facility floor may hinder the placement of the tool above the floor 500. Accordingly, in another aspect of the present description, it is believed that such facility conduits may be readily pressed downward (block 850) to permit the tool 300 to be moved into place within the footprint 610. It is believed that relatively stiff facility conduits such as gas line weldment conduits nonetheless retain sufficient flexibility after installation to the facility source (or other intermediate facility support points) to permit a sufficient degree of movement to permit the tool 300 to be placed within the proper footprint 610.

Once the wafer processing tool 300 is placed at the proper location within the footprint 610, the facility conduits may be displaced (block 860) upwardly, as needed, and coupled to the tool 300 as shown in FIG. 6. A suitable conduit 862 may be connected at one end to the connect-disconnect coupler 604 at the end of each facility conduit emerging from the floor 500. The conduit 862 may be connected at its other end to the intended connect-disconnect coupler 864 on the body of the tool 300 as shown in FIG. 6.

In another operation, the facility conduits may optionally be locked (block 870) to additional facility structures intermediate the floor 500 and the facility source 602. Securing the facility conduits in such a manner may be appropriate for earthquake preparedness or other concerns.

The entire lengths of the facility conduits may be checked for leaks and proper electrical connections. Upon positive results, the facility conduits may be coupled to their respective sources and supplies external to the wafer processing tool 202 for subsequent use.

In the illustrated embodiments, the templates 100, 200a, 200b, 200c may be made of tough, break resistant, transparent plastics such as polycarbonate. One suitable plastic is marketed under the name Lexan^{™}. It is appreciated that other materials may be utilized including metal or wood or other types of plastic.

In another aspect, the thickness of the plate-shaped template 100 may be, for example, 3.175 mm (1/8 of an inch). Such a thickness facilitates the template being able to support its own weight when extending across a relatively wide cutout and also sufficiently secure the facility conduits being located by the template. It is appreciated that other thicknesses may be utilized as well.

In the illustrated embodiment, the template 100 has an overall dimension of approximately 838.2 mm (33 inches) by 889 mm (35 inches). The orthogonally angled recesses 704a, 704b extend approximately 127 mm (5 inches) by 177.8 mm (7 inches). The obtuse angled (135 degree) recesses 708a, 708b extend approximately 203.2 mm (8 inches) by 330.2 mm (13 inches). The foreline apertures have a diameter of 120.65 mm (4.75 inches) and most of the remaining apertures of the template 100 have a diameter of 50.8 mm (2 inches). It is appreciated that other dimensions may be used. However, it is believed that the illustrated dimensions are particularly suitable for the illustrated embodiment.

In the illustrated embodiment, each template 200a, 200b, 200c has an overall dimension of approximately 101.6 mm (4 inches) by 838.2 mm (33 inches) and a thickness of approximately 2.54 mm (one tenth of an inch). The chamfered recess 720 is angled at an angle of 45 degrees and has a width of approximately 69.85 mm (2.75 inches). Each of the apertures 202 has a diameter of 31.75 mm (1.25 inches). It is appreciated that other dimensions may be used. However, it is believed that the illustrated dimensions are particularly suitable for the illustrated embodiment.

The foregoing description of various embodiments has been presented for the purposes of illustration and description. It is not intended to be exhaustive or to limit the invention to the precise form disclosed. Many modifications and variations are possible in light of the above teaching. For example, it is appreciated that the shapes and sizes of the templates may vary, depending upon the application. Furthermore, the operations illustrated in FIG. 4 may be performed in an order of operations different from that depicted. Still further, operations may be added and operations may be deleted from those depicted. It is intended that the scope of the invention not be limited by this detailed description.

## Claims

1. An apparatus for installing a plurality of facility conduits in a wafer fabrication facility for subsequent coupling to a wafer processing tool (300), said apparatus comprising: a flat, plate-shaped template (100; 200; 200a-c) adapted for facilities integration, said template defining a plurality of apertures (102; 202) arranged in a predetermined pattern of locations, each template aperture adapted to position a facility conduit passing through said each template aperture in a predetermined location to facilitate subsequently coupling the positioned facility conduit to the wafer processing tool.

2. The apparatus of claim 1 wherein wafer fabrication facility has a floor (500; 600) having a plurality of protruding fixtures (640) extending above a top surface (606) of said floor (500; 600), and wherein said template is adapted to be removably fastened to said top surface of said floor, and wherein said template defines a plurality of recesses (650a, 650b, 650c, 650d) positioned on the periphery of said template and adapted to receive protruding facility floor fixtures to permit said template to be fastened on and parallel to said floor top surface.

3. The apparatus of claim 2 wherein said template has a generally rectangular shaped central portion and three generally rectangular extension portions which define two generally rectangular recesses of said plurality of recesses, said template having a generally trapezoidal shaped extension which defines with two adjacent rectangular extension portions, two generally triangular shaped recesses of said plurality of recesses.

4. The apparatus of any of claims 1 to 3, wherein said template is made of transparent polycarbonate plastic.

5. The apparatus of any of claims 1 to 4, wherein each of said plurality of template apertures (102; 202) is sized to circumscribe a corresponding facility conduit, and wherein said plurality of facility conduits comprises liquid conduits.

6. The apparatus of any of claims 1 to 5, wherein each of said plurality of template apertures is sized to circumscribe a corresponding facility conduit, and wherein said plurality of facility conduits comprises at least one gas supply conduit, at least one gas exhaust conduit, at least one gas vent conduit, at least one liquid supply conduit, at least one gas return conduit, and at least one power conduit.

7. The apparatus of claim 6 wherein said gas conduits are weldments.

8. The apparatus of any of claims 1 to 7, wherein said wafer processing tool has a mainframe and three processing chambers coupled to said mainframe, said template pattern of locations defining four separate and distinct clusters of template apertures, one cluster of template apertures for each of said processing chambers and said mainframe, wherein said clusters do not overlap.

9. The apparatus of any of claims 1 to 8, wherein said wafer fabrication facility has a floor (500; 600) which defines a cutout (502; 502a) through which facility conduits pass, said template being adapted to be fastened over said cutout in said floor of said wafer fabrication facility.

10. The apparatus of any of claims 1 to 9, wherein said template (100; 200) is adapted to be positioned on and parallel to, and fastened to, a top surface of said floor.

11. The apparatus of claim 10 further comprising at least one fastener (628) wherein said template is adapted to be secured to said floor top surface utilizing said at least one fastener.

12. The apparatus of any of claims 1 to 11, wherein wafer fabrication facility has a floor having a plurality of protruding fixtures extending above a top surface of said floor, and wherein said template is adapted to be removably fastened to said top surface of said floor, and wherein said template is generally rectangular in shape and defines a recess positioned at one corner of the periphery of said template and adapted to receive protruding facility floor fixtures to permit said template to be fastened on and parallel to said floor top surface.

13. The apparatus of claim 12 wherein each of said plurality of template apertures is sized to circumscribe a corresponding facility conduit, and wherein said plurality of facility conduits are gas and liquid supply conduits.

14. A method of installing a plurality of facility conduits in a wafer fabrication facility for subsequent coupling to a wafer processing tool, said method comprising: determining a location where said wafer processing tool is to be positioned in said wafer fabrication facility; forming a cutout (502) in a floor of said fabrication facility corresponding to said location; providing said plurality of facility conduits through said cutout in said floor; mounting a flat, plate-shaped template (100; 200) defining a plurality of apertures arranged in a predetermined pattern of locations, to said floor and over said cutout in said floor; passing a facility conduit through each template aperture to position the facility conduit passing through each template aperture in a predetermined location; and coupling said wafer processing tool to said facility conduits.

15. The method of claim 14 further comprising coupling each of said facility conduits to a facility source and unmounting and removing said template from said floor before coupling said wafer processing tool to said facility conduits.

16. The method of claim 15 further comprising pushing facility conduits down, positioning said wafer processing tool over a footprint (610); and pulling said facility conduits up before coupling said wafer processing tool to said pulled up facility conduits.

17. The method of claim 16. further comprising locking facility conduits to a facility structure between the associated facility source and the wafer processing tool after coupling said wafer processing tool to said facility conduits.

18. The method of any of claims 14 to 17, wherein said determining step further comprises the steps of: measuring said fabrication facility utilizing X-Y coordinates relative to a facility datum point; and measuring a footprint (610) of said wafer processing tool.

19. The method of claim 18 wherein said footprint includes at least one template fastening point at which said template is mounted to said floor.

20. The method of any of claims 14 to 19, wherein said floor (500; 600) is a raised floor and wherein said providing further comprises routing said plurality of facility conduits beneath said raised floor of said fabrication facility.

21. The method of claim 20 wherein said plurality of conduits extends through said cutout and perpendicular to said raised floor.
